# EUROPEAN PATENT SPECIFICATION

(11) **EP 2 870 897 B1**
(45) Date of publication and mention of the grant of the patent: **27.04.2016**
(21) Application number: 13192151.2
(22) Date of filing: 08.11.2013
(51) Int. Cl.: A47B 88/04, H05K 7/14

(54) **Slide rail assembly**
Schienenanordnung
Ensemble de rail de glissement

(43) Date of publication of application: 13.05.2015
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Huang, Chien-Li, Kaohsiung City (TW); Wang, Chun-Chiang, Kaohsiung City (TW)
(74) Representative: Viering, Jentschura & Partner mbB Patent- und Rechtsanwälte

(56) References cited:
- US-A1- 2001 040 203
- US-A1- 2004 079 712
- US-A1- 2004 104 184
- US-A1- 2009 101 603

## Description

### BACKGROUND OF THE INVENTION

### 1. Fields of the invention

The present invention relates to a slide rail assembly, and more particularly, to a slide assembly suitable for installing the chassis of different sizes and providing sufficient support to improve the stability of the chassis installation.

### 2. Descriptions of Related Art

U.S. Patent No. 8,356,718, U.S. Patent No. 6,681,942 and U.S. Patent No. 7,823,994 discloses the conventional slide rail assemblies utilized in rack systems and are incorporated herein by reference. However, these conventional slide rail assemblies are not adapted to the chassis of different sizes such that those conventional slide rail assemblies cannot provide sufficient support to the longer

A slide rail assembly according to the preamble of claim 1 is known from US 2004/0079712 A1.

The present invention intends to provide a slide rail assembly that is adapted to the racks of different sizes and the chassis of different sizes as well so as to provide sufficient support for the chassis and improve the stability of the chassis installation.

### SUMMARY OF THE INVENTION

The present invention relates to a slide rail assembly. The slide rail assembly comprises a first rail, a second rail slidably connected to the first rail, and a third rail connected to the first rail and having a support portion; characterized in that the slide rail assembly further comprises a support member movably connected to the third rail and having a stop portion and a resilient member for generating an elastic force in response to a relative movement between the support member and the third rail.

According to the invention a chassis is located on the support portion, and the stop portion of the support member is located corresponding to the chassis and contacts against the chassis by the elastic force generated by the resilient member.

According to the invention the first rail has a first hook portion. The third rail has a window. The support member has a second hook portion extending through the window and located corresponding to the first hook portion. The resilient member is connected between the first and second hook portions.

Preferably, the support member has a first slot and a second slot. A first connecting member and a second connecting member extend through the first slot and the second slot, respectively, and are connected to the third rail.

Preferably, the third rail has a threaded portion located corresponding to the first slot of the support member. A screw member extends through the first slot of the support member and is engaged with the threaded portion.

Preferably, the third rail has a side plate, and the support portion extends perpendicularly from a bottom of the side plate. The support member has a side portion, and the stop portion is perpendicularly connected to the side portion. The side portion has at least one first slot, and a first connecting member extends through the at least one first slot and is connected to the side plate of the third rail.

Preferably, the side portion of the support member has a second slot. A second connecting member extends through the second slot and is connected to the side plate of the third rail.

Preferably, the third rail has a threaded portion located corresponding to the at least one first slot of the support member. A screw member extends through the at least one first slot of the support member and is engaged with the threaded portion.

Preferably, the slide rail assembly further comprises a cable management arm connected to the support member.

Preferably, the first rail has a top wall, a bottom wall and a side wall. The side wall is connected between the top and bottom walls. The third rail has a first lateral plate and a second lateral plate. The first lateral plate extends from a top of the side plate of the third rail. The first lateral plate is substantially perpendicular to the side plate. The second lateral plate extends downwardly from the first lateral plate. The second lateral plate is substantially perpendicular to the first lateral plate. The first and second lateral plates form a hook coupled with the top wall of the first rail such that the third rail is hung on the first rail by the hook.

The present invention yet provides a rack system having a slide rail assembly. The rack system comprises a rack having two first posts and two second posts, wherein the slide rail assembly is connected between a respective one of the two first posts and a respective one of the two second posts; a second slide rail assembly connected between the other one of the two first posts and the other one of the two second posts; the chassis installed between the slide rail assembly and the second slide rail assembly, characterized in that a first support part connects the first rail of the slide rail assembly to the respective one of the two first posts, and a second support part connects the second rail of the slide rail assembly to the respective one of the two second posts.

The present invention will become more obvious from the following description when taken in connection with the accompanying drawings which show, for purposes of illustration only, a preferred embodiment in accordance with the present invention.

### BRIEF DESCRIPTION OF THE DRAWINGS

FIG. 1 is an exploded view of a slide rail assembly in accordance with a preferred embodiment of the present invention;
FIG. 2 is a cross sectional view of the slide rail assembly in accordance with the preferred embodiment of the present invention;
FIG. 3A is an enlarged view of a portion of the slide rail assembly in accordance with the preferred embodiment of the present invention;
FIG. 3B is another angle view of the portion shown in FIG. 3A;
FIG. 4 is a schematic view that illustrates a chassis being installed to a rack by the slide rail assembly in accordance with the preferred embodiment of the present invention;
FIG. 5 is a side view that illustrates the installation of a chassis having a first length;
FIG. 6 is a schematic view of a support member of the slide rail assembly in accordance with the preferred embodiment of the present invention, in which the support member is not yet pulled;
FIG. 7 is a schematic view of the support member shown in FIG.6, in which the support member is pulled, and
FIG. 8 is a side view that illustrates the installation of a chassis having a second length.

### DETAILED DESCRIPTION OF THE PREFERRED EMBODIMENT

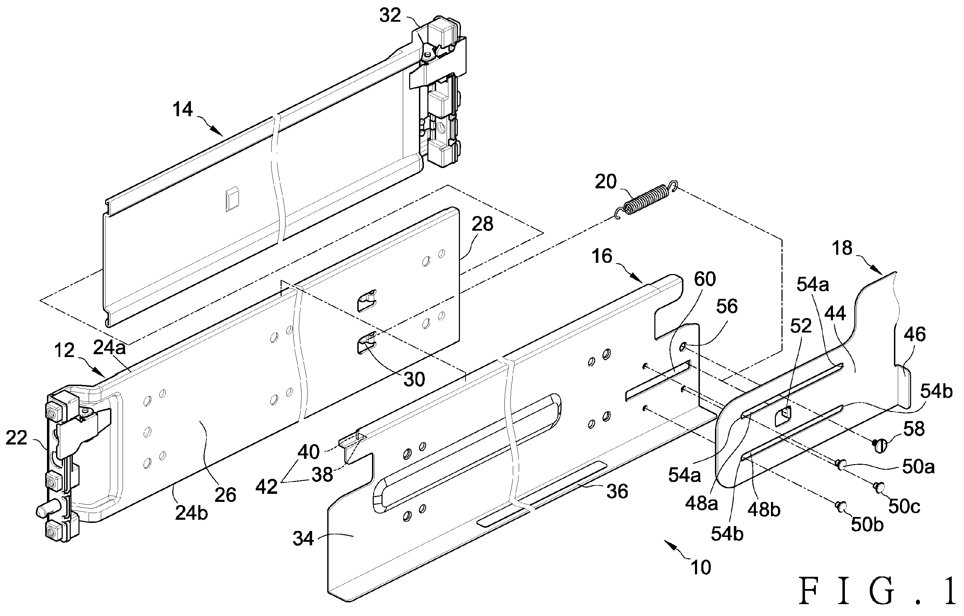

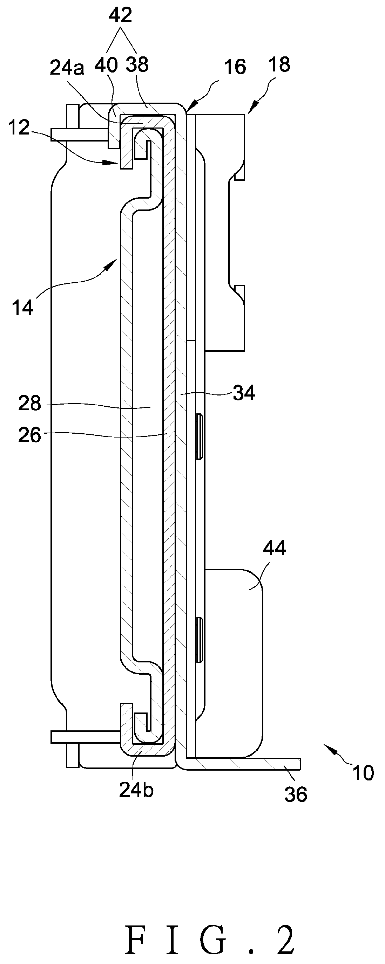

FIGS. 1 and 2 show a slide rail assembly 10 in accordance with a preferred embodiment of the present invention. The slide rail assembly 10 comprises a first rail 12, a second rail 14 slidably connected to the first rail 12, a third rail 16 connected to the first rail 12, a support member 18 movably connected to the third rail 16, and a resilient member 20 connected between the support member 18 and the first rail 12. The resilient member 20 generates an elastic force in response to a relative movement between the support member 18 and the third rail 16.

The first rail 12 is connected to a first support part 22 used to install the first rail 12 to a position of a rack (not shown in FIGS. 1 and 2). The first rail 12 has a top wall 24a, a bottom wall 24b and a side wall 26. The side wall 26 is connected between the top and bottom walls 24a, 24b such that the top wall 24a, the bottom wall 24b and the side wall 26 define a longitudinal passage 28. Further, a first hook portion 30 is formed on the side wall 26.

The second rail 14 is connected to a second support part 32 used to install the second rail 14 to another position of a rack (not shown in FIGS. 1 and 2). The second rail 14 is slidably coupled to the longitudinal passage 28 and allowed to slide along the longitudinal passage 28 relative to the first rail 12 so as to adjust the extended length of the slide rail assembly 10.

The third rail 16 is connected to the first rail 12 and has a side plate 34 and a support portion 36. The support portion 36 extends perpendicularly from a bottom of the side plate 34. Preferably, the third rail 16 has a first lateral plate 38 and a second lateral plate 40. The first lateral plate 38 extends from a top of the side plate 34 and is substantially perpendicular to the side plate 34. The second lateral plate 40 extends downwardly from an edge of the first lateral plate 38 and is substantially perpendicular to the first lateral plate 38. The first and second lateral plates 38, 40 form a hook 42 that is coupled with the top wall 24a of the first rail 12 such that the third rail 16 is hung on the first rail 12 by the hook 42.

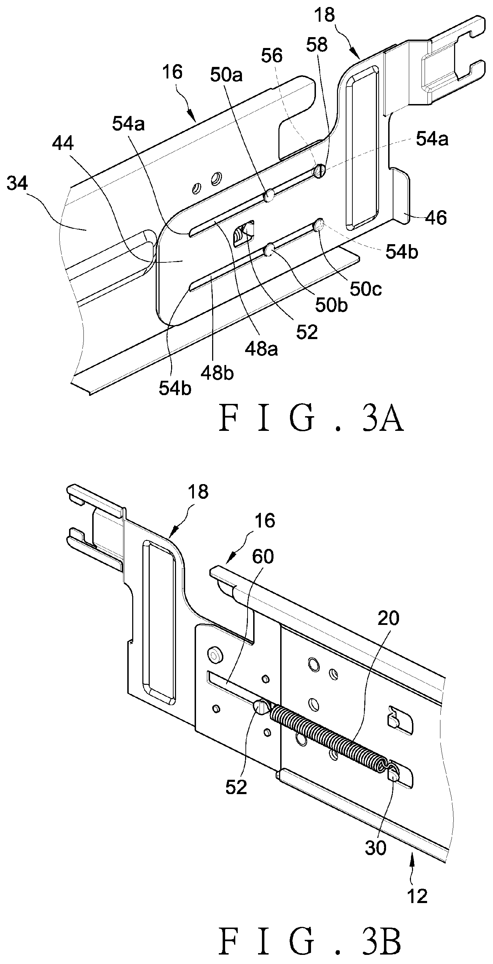

FIG. 3A shows that the support member 18 is movably connected to the third rail 16. The support member 18 has a side portion 44 and a stop portion 46 connected and substantially perpendicular to the side portion 44. The side portion 44 has a first slot 48a and a second slot 48b. A first connecting member 50a and a second connecting member 50b extend through the first slot 48a and the second slot 48b, respectively, and are connected to the side plate 34 of the third rail 16 such that the support member 18 is connected to the third rail 16. The support member 18 is guided by the first and second connecting members 50a, 50b to move relative to the third rail 16 in longitudinal direction. Preferably, a third connecting member 50c extends through the second slot 48b and is connected to the side plate 34 of the third rail 16. Further, the side portion 44 has a second hook portion 52.

The first, second and third connecting members 50a, 50b, 50c may be three individual members which are secured to the side plate 34 of the third rail 16 by rivets or other connection means. Alternatively, the first, second and third connecting members 50a, 50b, 50c may be integrally formed with the third rail 16 and be deemed as a portion of the third rail 16. The side portions 44 has an end face 54a located adjacent to the two ends of the first slot 48a and another end face 54b located adjacent to the two ends of the second slot 48b. The end faces 54a, 54b define the boundaries of the first and second slots 48a, 48b, respectively, to prevent the support member 18 from being disconnected from the third rail 16 when the support member 18 moves relative to the third rail 16.

Preferably, the third rail 16 has a threaded portion 56 located corresponding to the first slot 48a of the support member 18 such that a screw member 58 is allowed to extend through the first slot 48a of the support member 18 to engage with the threaded portion 56. Specifically, the threaded portion 56 is a threaded hole or the like; thereby, after the support member 18 is moved relative to the third rail 16 and located at an appropriate position, the screw member 58 is firmly engaged with the threaded portion 56 to secure the support member 18 to the third rail 16.

FIG. 3B shows that the resilient member 20 are connected between the first hook portion 30 of the first rail 12 and the second hook portion 52 of the support member 18. According to the invention the third rail 16 has a window 60, and the second hook portion 52 extends through the window 60 and is located corresponding to the first hook portion 30. Therefore, the resilient member 20 generates the elastic force in response to the relative movement between the support member 18 and the third rail 16.

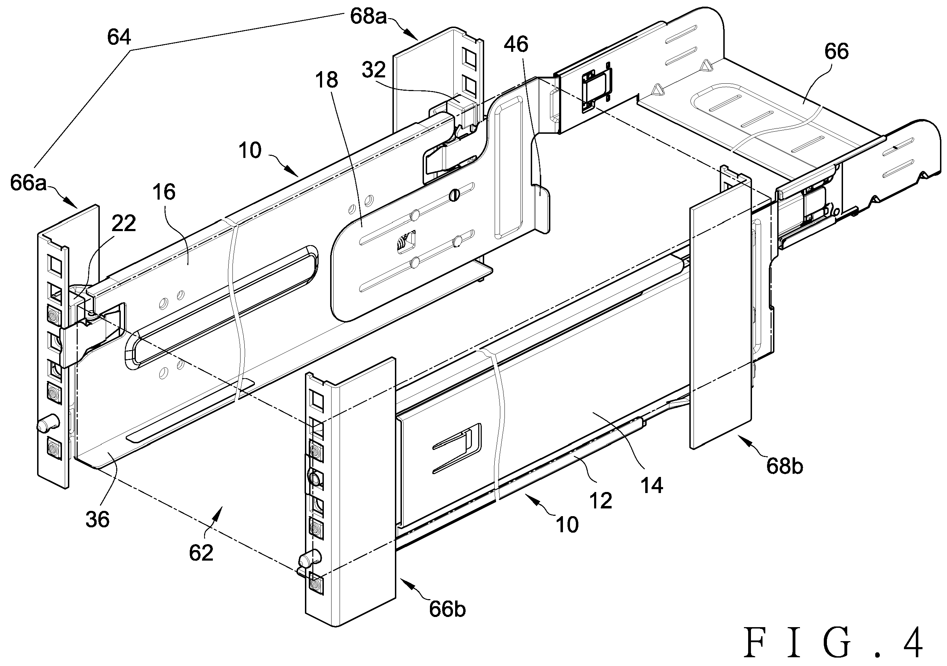

FIG. 4 shows a rack system in accordance with a preferred embodiment of the present invention. In this embodiment, the rack system comprises two identical slide rail assemblies 10 that are symmetrically located and used to install a chassis 62 to a rack 64. The extended length of each of the two slide rail assemblies 10 can be adjusted to reach a desired length that corresponds to the longitudinal depth of the rack 64 by moving the second rail 14 relative to the first rail 12 such that the two slide rail assemblies 10 are adapted to racks 64 of different sizes. Specifically, the rack 64 comprises two first posts 66a, 66b and two second posts 68a, 68b. The first rail 12 of each of the two slide rail assemblies 10 is respectively connected to one of the two first posts 66a, 66b by the first support part 22, and the second rail 14 of each of the two slide rail assemblies 10 is respectively connected to one of the two second posts 68a, 68b by the second support part 32. Thereby, the chassis 62 is allowed to be positioned on the two slide rail assemblies 10 with the bottom of the chassis 62 supported by the support portions 36 of the third rails 16 of the two slide rail assemblies 10. Furthermore, the support member 18 of each of the two slide rail assemblies 10 is able to be moved according to the length of the chassis 62 and permits the stop portion 46 thereof to contact against the chassis 62. Preferably, a cable management arm 66 is connected to the support members 18 of the two slide rail assemblies 10 to manage the cables (not shown) of the chassis 62.

It should be noted that the embodiment of which comprises two slide rail assemblies 10 as described above is used to exemplify the installation of the chassis 62 rather than limit the number of the slide rail assembly 10.

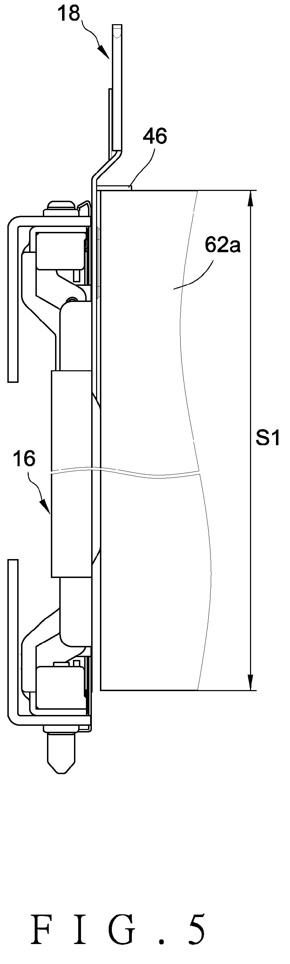

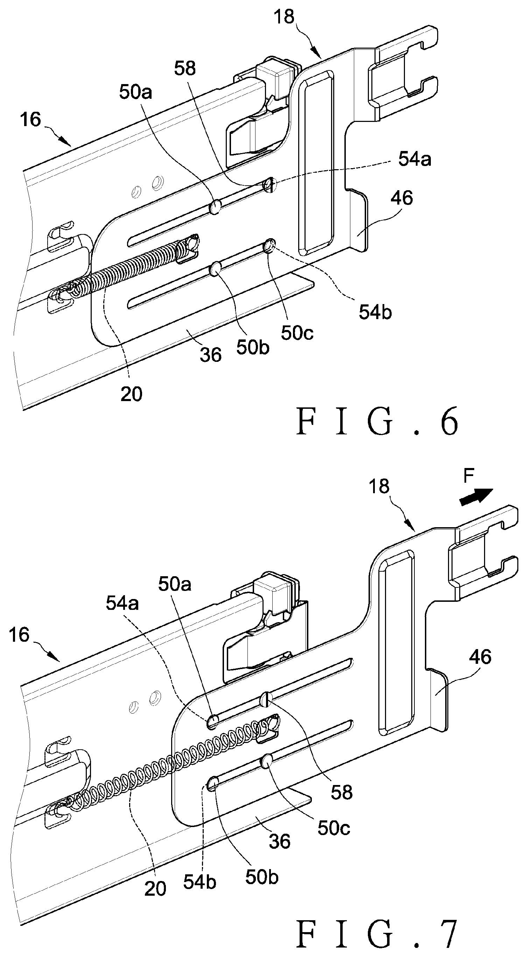

FIG. 5 shows a chassis 62a having a first length S1, in which the support member 18 is retracted to a minimum extended position (as shown in FIG. 6) by the resilient member 20, and the stop portion 46 of the support member 18 contacts against the chassis 62a and provides a lateral support for the chassis 62a. Therefore, the chassis 62a is well supported and positioned by the support portion 36 of the third rail 16 and the stop portion 46 of the support member 18.

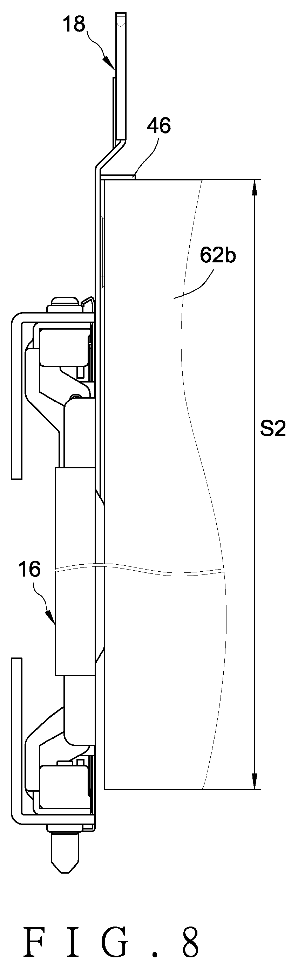

FIG. 8 shows a chassis 62b having a second length S2 longer than the first length S 1. To accommodate the chassis 62b, a force F of a first direction (as shown in Fig. 7) is applied to the support member 18 to pull the support member 18 to move relative to the third rail 16, such that the resilient member 20 is extended and simultaneously generates a continuous elastic force of a second direction, opposite to the first direction, in response to the relative movement between the support member 18 and the third rail 16. The continuous elastic force of the second direction keeps the stop portion 46 of the support member 18 contacting against the chassis 62b. In addition, the connection between the support member 18 and the third rail 16 can be improved by firmly engaging the screw member 58 with the threaded portion 56 after the stop portion 46 of the support member 18 contacts against the chassis 62b. Therefore, the chassis 62b also can be well supported and positioned by the support portion 36 of the third rail 16 and the stop portion 46 of the support member 18.

Furthermore, it is noted that the support member 18 is guided by the first, second and third connecting members 50a, 50b, 50c to move relative to the third rail 16 in longitudinal direction. Preferably, the end faces 54a, 54b of the support member 18 contact the first and second connecting members 50a, 50b to stop the support member 18 when the support member 18 moves to a maximum extended position (as shown in FIG. 7). Similarly, the end face 54b of the support member 18 contacts the third connecting member 50c to stop the support member 18 when the support member 18 moves to the minimum extended position (as shown in FIG. 6). Therefore, the end faces 54a, 54b prevent the support member 18 from being disconnected from the third rail 16.

In conclusion, the support portion 36 of the third rail 16 and the stop portion 46 of the support member 18 can provide a sufficient support to the chassis 62a and the chassis 62b individually. In other words, the present invention is adapted to chassis 62 of different sizes.

While we have shown and described the embodiment in accordance with the present invention, it should be clear to those skilled in the art that further embodiments may be made without departing from the scope of the present invention.

## Claims

1. A slide rail assembly (10), comprising:
a first rail (12);
a second rail (14) slidably connected to the first rail (12); and
a third rail (16) connected to the first rail (12) and having a support portion (36); a support member (18) movably connected to the third rail (16) and having a stop portion (46) and
a resilient member (20) for generating an elastic force in response to a relative movement between the support member (18) and the third rail (16),
**characterized in that** a chassis (62) is located on the support portion (36), and the stop portion (46) of the support member (18) is located corresponding to the chassis (62) and contacts against the chassis (62) by the elastic force generated by the resilient member (20), and wherein the first rail (12) has a first hook portion (30), the third rail (16) has a window (60), the support member (18) has a second hook portion (52) extending through the window (60) and located corresponding to the first hook portion (30), and the resilient member (20) is connected between the first and second hook portions (30, 52).

2. The slide rail assembly as claimed in claim 1, wherein the support member (18) has a first slot (48a) and a second slot (48b), and a first connecting member (50a) and a second connecting member (50b) extend through the first slot (48a) and the second slot (48b), respectively, and are connected to the third rail (16).

3. The slide rail assembly as claimed in claim 1, wherein the support member (18) has a first slot (48a), the third rail (16) has a threaded portion (56) located corresponding to the first slot (48a) of the support member (18), and a screw member (58) extends through the first slot (48a) of the support member (18) and is engaged with the threaded portion (56).

4. The slide rail assembly as claimed in claim 1, wherein the third rail (16) has a side plate (34), the support portion (36) extends perpendicularly from a bottom of the side plate (34), the support member (18) has a side portion (44), the stop portion (46) is perpendicularly connected to the side portion (44), the side portion (44) has at least one first slot (48a), and a first connecting member (50a) extends through the at least one first slot (48a) and is connected to the side plate (34) of the third rail (16).

5. The slide rail assembly as claimed in claim 4, wherein the side portion (44) of the support member (18) has a second slot (48b), and a second connecting member (50b) extends through the second slot (48b) and is connected to the side plate (34) of the third rail (16).

6. The slide rail assembly as claimed in claim 4, wherein the third rail (16) has a threaded portion (56) located corresponding to the at least one first slot (48a) of the support member (18), and a screw member (58) extends through the at least one first slot (48a) of the support member (18) and is engaged with the threaded portion (56).

7. The slide rail assembly as claimed in claim 4, further comprising a cable management arm (66) connected to the support member (18).

8. The slide rail assembly as claimed in claim 4, wherein the first rail (12) has a top wall (24a), a bottom wall (24b) and a side wall (26), the side wall (26) is connected between the top and bottom walls (24a, 24b), the third rail (16) has a first lateral plate (38) and a second lateral plate (40), the first lateral plate (38) extends from a top of the side plate (34) of the third rail (16), the first lateral plate (38) is substantially perpendicular to the side plate (34), the second lateral plate (40) extends downwardly from the first lateral plate (38), the second lateral plate (40) is substantially perpendicular to the first lateral plate (38), and the first and second lateral plates (38, 40) form a hook (42) coupled with the top wall (24a) of the first rail (12) such that the third rail (16) is hung on the first rail (12) by the hook (42).

9. A rack system having a slide rail assembly (10) as claimed in claim 1, comprising:
a rack (64) having two first posts (66a, 66b) and two second posts (68a, 68b), wherein the slide rail assembly (10) is connected between a respective one of the two first posts (66a) and a respective one of the two second posts (68a);
a second slide rail assembly connected between the other one of the two first posts (66b) and the other one of the two second posts (68b); and
the chassis (62) installed between the slide rail assembly (10) and the second slide rail assembly, **characterized in that** a first support part (22) connects the first rail (12) of the slide rail assembly (10) to the respective one of the two first posts (66a), and a second support part (32) connects the second rail (14) of the slide rail assembly (10) to the respective one of the two second posts (68a).

## Patentansprüche

1. Eine Montage (10) einer Gleitschiene, umfassend:
einer ersten Schiene (12);
einer zweiten Schiene (14), die gleitbar mit der ersten Schiene (12) verbunden ist; und
einer dritten Schiene (16), die mit der ersten Schiene (12) verbunden und
mit einem Stützabschnitt (36) gebildet ist;
einem Stützglied (18), das beweglich an der dritten Schiene (16) befestigt und mit einem Anschlagteil (46) gebildet ist und
einer Feder (20), mit der eine Spannkraft als Reaktion auf eine Relativbewegung zwischen dem Stützglied (18) und der dritten Schiene (16) erzeugt wird, **dadurch gekennzeichnet, dass** ein Gleitwerk (62) auf dem Stützabschnitt (36) und das Anschlagteil (46) des Stützgliedes (18) in Übereinstimmung mit dem Gleitwerk (62) angeordnet sind und das Anschlagteil (46) dabei durch die mit der Feder (20) erzeugten Spannkraft an das Gleitwerk (62) angedrückt wird; die erste Schiene (12) mit einem ersten Hakenteil (30) und die dritte Schiene (16) mit einer Öffnung (60) gebildet sind; das Stützglied (18) ein zweites Hakenteil (52) aufweist, das durch die Öffnung (60) ragt und in Übereinstimmung mit dem ersten Hakenteil (30) angeordnet ist; die Feder (20) zwischen dem ersten und dem zweiten Hakenteil (30, 52) befestigt ist.

2. Die Montage einer Laufschiene nach Anspruch 1, wobei das Stützglied (18) eine erste Schlitzöffnung (48a) und eine zweite Schlitzöffnung (48b) aufweist; ein erstes Verbindungsteil (50a) und ein zweites Verbindungsteil (50b) durch die erste Schlitzöffnung (48a) bzw. durch die zweite Schlitzöffnung (48b) ragen und an der dritten Schiene (16) befestigt sind.

3. Die Montage einer Laufschiene nach Anspruch 1, wobei das Stützglied (18) eine erste Schlitzöffnung (48a) aufweist; die dritte Schiene (16) in Übereinstimmung mit der ersten Schlitzöffnung (48a) des Stützgliedes (18) mit einem Gewindeloch (56) gebildet ist; eine Schraube (58) durch die erste Schlitzöffnung (48a) des Stützgliedes (18) ragt und in das Gewindeloch (56) eingeschraubt ist.

4. Die Montage einer Laufschiene nach Anspruch 1, wobei an der dritten Schiene (16) eine Seitenplatte (34) befestigt ist; sich der Stützabschnitt (36) senkrecht von einer Unterseite der Seitenplatte (34) erstreckt; das Stützglied (18) ein seitliches Teil (44) aufweist; das Anschlagteil (46) senkrecht am seitlichen Teil (44) befestigt ist; das seitliche Teil (44) mit mindestens einer ersten Schlitzöffnung (48a) gebildet ist; ein erstes Verbindungsteil (50a) durch die mindestens eine Schlitzöffnung (48a) ragt und an der Seitenplatte (34) der dritten Schiene (16) befestigt ist.

5. Die Montage einer Laufschiene nach Anspruch 4, wobei das seitliche Teil (44) des Stützgliedes (18) eine zweite Schlitzöffnung (48b) aufweist; ein zweites Verbindungsteil (50b) durch die zweite Schlitzöffnung (48b) ragt und an der Seitenplatte (34) der dritten Schiene (16) befestigt ist.

6. Die Montage einer Laufschiene nach Anspruch 4, wobei die dritte Schiene (16) mit einem Gewindeloch (56) gebildet ist, das in Übereinstimmung mit der mindestens einen ersten Schlitzöffnung (48a) des Stützgliedes (18) geformt ist; eine Schraube (58) durch die mindestens eine Schlitzöffnung (48a) des Stützgliedes (18) ragt und in das Gewindeloch (56) eingeschraubt ist.

7. Die Montage einer Laufschiene nach Anspruch 4, weiter umfassend einem Kabelführungsarm (66), das am Stützglied (18) befestigt ist.

8. Die Montage einer Laufschiene nach Anspruch 4, wobei die erste Schiene (12) ein oberes Wandteil (24a), ein unteres Wandteil (24b) und eine Seitenwand (26) aufweist; die Seitenwand (26) zwischen den oberen und unteren Wandteile (24a, 24b) befestigt ist; die dritte Schiene (16) mit einer ersten seitlichen Platte (3 8) und mit einer zweiten seitlichen Platten (40) gebildet ist; sich die erste seitliche Platte (38) von einer Oberseite der Seitenplatte (34) der dritten Schiene (16) erstreckt; die erste seitliche Platte (38) im Wesentlichen senkrecht zur Seitenplatte (34) angeordnet ist; sich die zweite seitliche Platte (40) von der ersten seitlichen Platte (38) nach unten erstreckt; die zweite seitliche Platte (40) im Wesentlichen senkrecht zur ersten seitlichen Platte (38) angeordnet ist; mit den ersten und zweiten seitlichen Platten (38, 40) ein Haken (42) gebildet wird, der am oberen Wandteil (24a) der ersten Schiene (12) so eingehakt ist, dass die dritte Schiene (16) mit dem Haken (42) an der ersten Schiene (12) aufgehängt ist.

9. Ein Aufhängersystem mit einer Montage (10) einer Laufschiene nach Anspruch 1, umfassend:
einem Aufhänge (64) mit zwei ersten Ständern (66a, 66b) und zwei zweiten Ständern (68a, 68b), wobei eine Montage (10) einer Laufschiene zwischen dem jeweiligen einen der beiden ersten Ständern (66a) und dem jeweiligen einen der beiden zweiten Ständern (68a) befestigt ist; eine zweite Montage einer Laufschiene zwischen dem anderen einen der beiden ersten Ständern (66b) und dem anderen einen der beiden zweiten Ständern (68b) befestigt ist; und
das Gleitwerk (62) zwischen der Montage (10) einer Laufschiene und der zweiten Montage einer Laufschiene installiert ist; **dadurch gekennzeichnet, dass** mit dem ersten Stützteil (22) die erste Schiene (12) der Montage (10) einer Laufschiene an den jeweils einen der beiden ersten Ständer (66a) und mit dem zweiten Stützteil (32) die zweite Schiene (14) der Montage (10) einer Laufschiene an den jeweils einen der beiden zweiten Ständer (68a) befestigt werden.

## Revendications

1. Un assemblage de rails coulissant (10), comprenant :
un premier rail (12) ;
un second rail (14) connecté de manière coulissante au premier rail (12) ; et
un troisième rail (16) connecté au premier rail (12) et ayant une partie de support (36) ;
un élément de support (18) connecté de manière mobile au troisième rail (16) et ayant une partie d'arrêt (46) et
un élément élastique (20) pour générer une force élastique en réponse à un mouvement relatif entre l'élément de support (18) et le troisième rail (16), **caractérisé en ce qu'**un châssis (62) est situé sur la partie de support (36), et la partie d'arrêt (46) de l'élément de support (18) est située en correspondance avec le châssis (62) et entre en contact avec le châssis (62) du fait de la force élastique générée par l'élément élastique (20), et dans lequel le premier rail (12) a une première partie en crochet (30), le troisième rail (16) a une fenêtre (60), l'élément de support (18) a une deuxième partie en crochet (52) se prolongeant à travers la fenêtre (60) et située en correspondance avec la première partie en crochet (30), et l'élément élastique (20) est connecté entre les première et deuxième parties en crochet (30, 52).

2. L'assemblage de rails coulissant selon la revendication 1, dans lequel l'élément de support (18) a une première rainure (48a) et une deuxième rainure (48b), et un premier élément de connexion (50a) et un deuxième élément de connexion (50b) se prolongent à travers la première rainure (48a) et la deuxième rainure (48b), respectivement, et sont connectés au troisième rail (16).

3. L'assemblage de rails coulissant selon la revendication 1, dans lequel l'élément de support (18) a une première rainure (48a), le troisième rail (16) a une partie filetée (56) située en correspondance avec la première rainure (48a) de l'élément de support (18), et un élément de vis (58) se prolonge à travers la première rainure (48a) de l'élément de support (18) et est engagé avec la partie filetée (56).

4. L'assemblage de rails coulissant selon la revendication 1, dans lequel le troisième rail (16) a une plaque latérale (34), la partie de support (36) se prolonge perpendiculairement à partir d'une partie inférieure de la plaque latérale (34), l'élément de support (18) a une partie latérale (44), la partie d'arrêt (46) est connectée perpendiculairement à la partie latérale (44), la partie latérale (44) comporte au moins une première rainure (48a), et un premier élément de connexion (50a) se prolonge à travers au moins une première rainure (48a) et est connecté à la plaque latérale (34) du troisième rail (16).

5. L'assemblage de rails coulissant selon la revendication 4, dans lequel la partie latérale (44) de l'élément de support (18) a une deuxième rainure (48b), et un deuxième élément de connexion (50b) se prolonge à travers la deuxième rainure (48b) et est connecté à la plaque latérale (34) du troisième rail (16).

6. L'assemblage de rails coulissant selon la revendication 4, dans lequel le troisième rail (16) a une partie filetée (56) située en correspondance avec au moins une première rainure (48a) de l'élément de support (18), et un élément de vis (58) se prolonge à travers au moins une première rainure (48a) de l'élément de support (18) et est engagé avec la partie filetée (56).

7. L'assemblage de rails coulissant selon la revendication 4, comprenant en outre un bras de gestion des câbles (66) connecté à l'élément de support (18).

8. L'assemblage de rails coulissant selon la revendication 4, dans lequel le premier rail (12) a une paroi supérieure (24a), une paroi inférieure (24b) et une paroi latérale (26), la paroi latérale (26) est connectée entre les parois supérieure et inférieure (24a, 24b), le troisième rail (16) a une première plaque latérale (38) et une deuxième plaque latérale (40), la première plaque latérale (38) se prolonge à partir d'un sommet de la plaque latérale (34) du troisième rail (16), la première plaque latérale (38) est substantiellement perpendiculaire à la plaque latérale (34), la deuxième plaque latérale (40) se prolonge vers le bas à partir de la première plaque latérale (38), la deuxième plaque latérale (40) est substantiellement perpendiculaire à la première plaque latérale (38), et les première et deuxième plaque latérales (38, 40) forment un crochet (42) couplé avec la paroi supérieure (24a) du premier rail (12) de sorte que le troisième rail (16) est accroché au premier rail (12) par le crochet (42).

9. Un système de bâti ayant un assemblage de rails coulissant (10) selon la revendication 1, comprenant :
un bâti (64) ayant deux premiers montants (66a, 66b) et deux deuxièmes montants (68a, 68b), dans lequel l'assemblage de rails coulissant (10) est connecté entre un montant respectif des deux premiers montants (66a) et
un montant respectif des deux deuxièmes montants (68a) ; un deuxième assemblage de rails coulissant connecté entre l'autre montant des deux premiers montants (66b) et l'autre montant des deux deuxièmes montants (68b) ; et
le châssis (62) installé entre l'assemblage de rails coulissant (10) et le deuxième assemblage de rails coulissant, **caractérisé en ce qu'**une première partie de support (22) connecte le premier rail (12) de l'assemblage de rails coulissant (10) au montant respectif des deux premiers montants (66a), et une deuxième partie de support (32) connecte le second rail (14) de l'assemblage de rails coulissant (10) au montant respectif des deux deuxièmes montants (68a).
